# EUROPEAN PATENT APPLICATION

(11) **EP 1 289 027 A1**
(43) Date of publication of application: **05.03.2003**
(21) Application number: 02078441.9
(22) Date of filing: 19.08.2002
(51) Int. Cl.: H01L 41/083, H01L 41/24

(54) **Multilayer piezoelectric actuator**

(30) Priority: 30.08.2001 EP 01203241
(71) Applicant: Océ-Technologies B.V., 5914 CC Venlo (NL)
(72) Inventor: Blom, Franciscus Richard, 5731 MK Mierlo (NL); Bisschop, Jacobus Johannes Maria, 5913 DL Venlo (NL)
(74) Representative: Rongen, Josephus Wilhelmus

(57) **Abstract**

A piezoelectric actuator having a body (22) with a front face, a rear face opposite to the front face, and first and second side faces opposite to one another, the body (22) being formed by several active layers (24-1, 24-2) of piezoelectric material with internal electrodes (1, 2) intervening therebetween, wherein the internal electrodes comprise a first group of electrodes (1) extending to the rear face of the body and connected to a first external electrode, and a second group (2) of electrodes extending to the front face of the body and connected to a second external electrode, characterized in that the electrodes (1) of the first group extend to the first side face of the block (22) and are buried in the block near the second side face thereof, whereas the electrodes (2) of the second group extend to the second side face of the block (22) and are buried in the block near the first side face.

## Description

The invention relates to a piezoelectric actuator having a body with a front face, a rear face opposite to the front face, and first and second side faces opposite to one another, the body being formed by several active layers of piezoelectric material with internal electrodes intervening therebetween, wherein the internal electrodes comprise a first group of electrodes extending to the rear face of the body and connected to a first external electrode, and a second group of electrodes extending to the front face of the body and connected to a second external electrode.

The invention further relates to a method of manufacturing such a piezoelectric actuator.

A piezoelectric actuator may be used in an ink jet device for use in an ink jet printer for pressuring liquid ink in order to expel an ink droplet from a nozzle of the printhead.

US-A-5 475 408 discloses an ink jet device with a piezoelectric actuator of the type indicated above.

It is preferable that the actuator has an even number of active layers and, accordingly, an uneven number of internal electrodes. Then, when the internal electrodes are numbered sequentially, the odd-numbered electrodes from the first group and may be grounded, so that an electromagnetic shielding is achieved by the lowermost and the topmost electrodes belonging to this group, whereas the even-numbered electrodes forming the second group serve as signal electrodes. The external electrodes are applied to the front face and the rear face of the body, respectively, so as to interconnect the exposed edges of the first and second group, respectively, of internal electrodes. It is observed here that the terms "front face" and "rear face" have been introduced only for distinguishing purposes and do not necessarily define the orientation of the actuator within the ink jet device.

In the known actuator, the internal electrodes of both the first and the second group extend to both side faces of the body. Thus, even when the external electrodes have been applied to the front and rear faces, the edges of the electrodes still remain exposed at the lateral side faces of the body. This has the drawback that short circuits may occur when, in the manufacturing process, a high voltage is applied between the first and second groups of electrodes in order to polarize the piezoelectric material.

Such short circuits may be avoided by an arrangement in which the lateral edges of the internal electrodes are spaced from the side faces of the body, so that the electrodes are buried in the piezoelectric material. Then, however, once the external electrodes have been applied, the internal electrodes are no longer visible from the outside, and it is difficult to decide which one of the external electrodes contacts the even numbered electrodes and which one contacts the odd-numbered electrodes. As a result, there is a risk that the electrical connections to the first and second external electrodes are confused either in the polarizing step or when the actuator is mounted in the ink jet device. In order to avoid such confusions, it is therefore necessary to provide a visible mark on the piezoelectric body, and this mark has to be applied in such a way, e.g. mechanically, that the mark will not be deleted when the piezoelectric body is exposed to high temperatures in a sintering step, in which green sheets of the piezoelectric material are sintered to form a piezoelectric ceramic. The necessity to provide a mark on the piezoelectric body requires an additional process step and therefore increases the complexity and costs of the manufacturing process for the ink jet device.

It is an object of the invention to facilitate the process of manufacturing the actuator.

According to the invention, this object is achieved by an actuator of the type indicated above, which is characterized in that the electrodes of the first group extend to the first side face of the block and are buried in the block near the second side face thereof, whereas the electrodes of the second group extend to the second side face of the block and are buried in the block near the first side face.

As a result, the electrodes of the first group of internal electrodes are visible on one side of the block, and the internal electrodes of the other group are visible on the other side, so that it is possible, by inspecting the arrangement and/or numbers of the electrodes visible on the side faces of the body, to distinguish between the first and second groups of internal electrodes even when the external electrodes have been applied. The corresponding external electrodes can then be identified on the basis of the known connection scheme between the internal and external electrodes. Nevertheless, the risk of short circuits in the polarizing step is avoided, because the edges of the internal electrodes of the first group are exposed only on the side of the block where the electrodes of the second block are buried, and vice versa.

A method of manufacturing an actuator according to the invention is indicated in the independent method claim, and useful optional features of the invention are specified in the dependent claims.

In order to achieve a high performance and long lifetime of the actuator, it is required to have a good and durable electric contact between the edges of the internal electrodes exposed at the front and rear faces of the body and the external electrodes applied to these faces. This objective is not easy to achieve, in particular in a practical multi-nozzle ink jet device in which the piezoelectric body of the actuator has only a width in the order of 0.1 mm, so that the area of contact between the internal and external electrodes is extremely small. On this scale, microscopic defects and effects like the so-called Kirkendall voiding may lead to poor electrical contact, when conventional electroless plating is used for applying the external electrodes. Since, according to the invention, the edges of the internal electrodes are exposed also on a lateral side face of the body, it is possible to apply an electric voltage to the electrodes (and in fact selectively to each individual group of internal electrodes) by contacting the exposed side edges of the electrodes. A preferred embodiment of the invention takes advantage of this fact by utilizing the side edges of the internal electrodes for temporarily applying a DC voltage so as to form galvanically grown contact portions on the edges of the internal electrodes exposed at the front and rear faces of the body before the external electrodes are applied. By forming such galvanically grown contact portions, the reliability and durability of electric contact between the internal electrodes and the external electrodes can be improved significantly. The temporary electric contact for applying a voltage to the internal electrodes during the galvanic process can be achieved with sufficient reliability because, in a practical actuator for an ink jet device, the length of the side face of the piezoelectric body is 10 to 100 times larger than the width of the front and rear faces of the body, so that microscopic defects on the side faces are not detrimental.

The concept to apply galvanically grown contact portions to the internal electrodes by electrically contacting the lateral edges of the internal electrodes is not limited to the case that the internal electrodes are exposed on only one of the two side faces. Thus, in a more general aspect, the invention also features a method of manufacturing a piezoelectric actuator, comprising the steps of:
- forming a body by laminating a plurality of layers of piezoelectric material with internal electrodes intervening therebetween, such that each internal electrode is exposed at one of opposite front and rear faces of the body and is also exposed at at least one of opposite side faces of the body,
- electrically contacting each internal electrode at the side face at which it is exposed,
- subjecting the body to a galvanic process for growing contact portions on the edges of each internal electrode exposed at one of said front and rear faces of the body, and
- forming an external electrode on at least one of said front and rear faces of the body for making permanent electrical contact with said contact portions of the internal electrodes.

A preferred embodiment of the invention will now be explained in conjunction with the accompanying drawings, in which:
- Fig. 1: is a simplified longitudinal section through an ink jet device with piezoelectric actuator;
- Fig. 2: is a perspective view of the piezoelectric actuator;
- Fig. 3: is a perspective view of the piezoelectric actuator shown in figure 2, from the rear side, corresponding to the arrow III in figure 2;
- Fig. 4: is a plan view of the piezoelectric actuator, with parts broken away, illustrating a manufacturing process for the actuator; and
- Fig. 5: is a diagram illustrating a galvanic process employed in manufacturing the piezoelectric actuator.

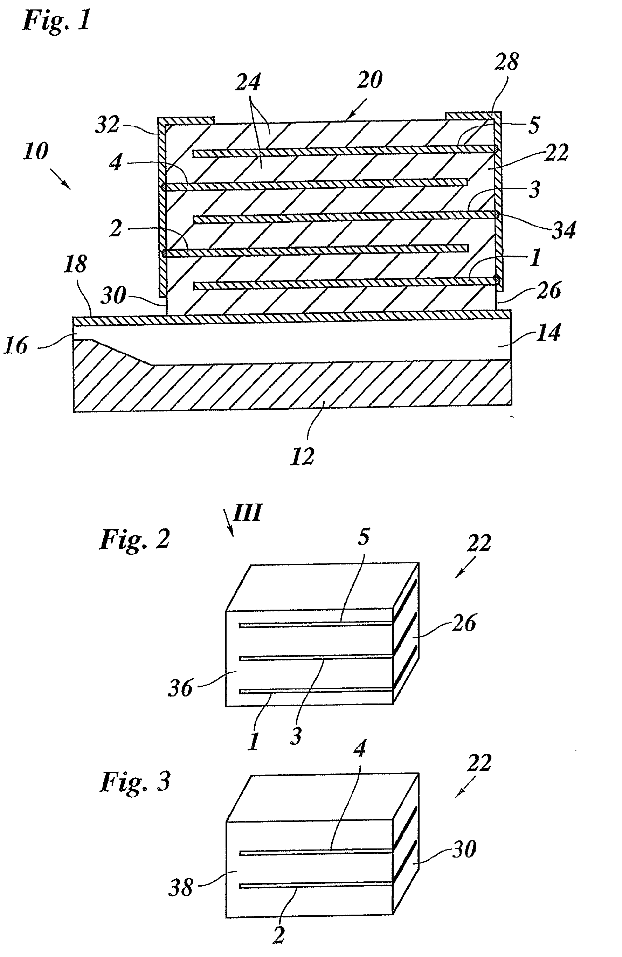

As is shown in figure 1, an ink jet device 10 for an ink jet printer comprises a channel plate 12 with a plurality of parallel ink channels 14 formed in its top surface. In the drawing, only one of the ink channels 14 can be seen in longitudinal section. Each ink channel 14 tapers towards a nozzle 16. The nozzles 16 of the various ink channels 14 are arranged with narrow regular spacings in the direction normal to the plane of the drawing in figure 1 and thus form a linear nozzle array. The ink channels 14 are covered by a flexible membrane 18. A separate piezoelectric actuator 20 is associated with each of the ink channels 14 and is placed on top of the membrane 18. In order to expel an ink droplet from the nozzle 16, the actuator 20 is activated so that it expands in vertical direction and deflects the membrane 18 downwardly so as to generate an acoustic pressure wave in the ink channel 14. This pressure wave propagates to the nozzle 16 and results in the ejection of an ink droplet from the nozzle.

The actuator 20 comprises a block 22 of piezoelectric ceramic material shaped as a parallelepiped. In a practical embodiment, the block 22 has a width dimension in the direction normal to the plane of the drawing in figure 1, which is only in the order of 0.1 mm, depending on the pitch of the nozzles 16 in the nozzle array. On the other hand, the length dimension in longitudinal direction of the ink channel 14 is in the order of several millimeters.

The block 22 has a laminated structure with an even number (6 in this simplified example) of layers 24 of piezoelectric material, with internal electrodes 1, 2, 3, 4, 5, intervening between the individual layers 24. It will be observed that the number of internal electrodes must be odd (5 in this example). The reference numerals 1, 2, 3, 4 and 5 for the internal electrodes can also be considered as ordinal numbers when the electrodes are counted from the bottom to the top of the block 22. The odd-numbered electrodes 1, 3, 5 form a first group of internal electrodes. These electrodes extend to a rear face 26 of the body 22 and are interconnected by a first external electrode 28 which has been applied to this rear face. The even-numbered electrodes 2, 4 form a second group of internal electrodes and extend to a front face 30 of the block 22, where they are interconnected by a second external electrode 32 which has been applied to the rear face.

A reliable electrical connection between the internal electrodes 1-5 and the respectively associated external electrodes 28 and 32 is achieved by contact portions 34 which are galvanically grown on the edges of the internal electrodes exposed at the front and rear faces 26, 30 of the block 22.

In the manufacturing process of the piezoelectric actuator 20, the external electrodes 28, 32 are used for applying a high voltage to the internal electrodes in order to produce an alternating pattern of polarizations in the piezoelectric layers 24. When the actuator 20 is operating in the printing device 10, the first group of electrodes 1, 3, 5 is grounded via the external electrode 28, whereas the internal electrodes 2, 4 of the second group serve as signal electrodes to which a voltage is applied via the external electrode 32, in order to energize the actuator.

In the polarizing step during the manufacturing process and also when the individual actuators 20 are mounted and electrically connected in the ink jet device 10, care must be taken that the positions and electrical connections of the external electrodes 28 and 32 are not confused. Even when the external electrodes 28 and 32 were confused in both the polarizing step and the mounting step, the effects would not cancel-out completely, because the total number of the odd-numbered electrodes 1, 3, 5 is larger than the total number of the even-numbered electrodes 2, 4.

Figures 2 and 3 show perspective views (not to scale) of the block 22 from opposite directions. It can be seen in figure 2 that the internal electrodes 1, 3, 5 of the first group, but not the internal electrodes 2, 4 of the second group, extend to a first side face 36 of the block 22, so that their edges are visible in this side face. Conversely, as is seen in figure 3, the internal electrodes 2, 4 of the second group, and only of this group, extend to the second side face 38 of the block 22 and are visible in this side face.

Figures 2 and 3 show a state in which the external electrodes 28, 32 have not been applied yet, so that the internal electrodes 1, 3, 5 are also visible at the rear face 26 of the block 22, and the internal electrodes 2, 4 are also visible at the front face 30 of the block. But even when the external electrodes 28, 32 have been applied and cover the edges of the internal electrodes at the front and rear faces 26, 30, the edges of the internal electrodes still remain visible at the side faces 36 and 38, so that the opposite orientations of the block 22 shown in figures 2 and 3 can still be distinguished from one another, and it can be determined without any risk of error how the voltages have to be applied to the first and second groups of internal electrodes in the polarizing step and how the block 22 has to be mounted in the ink jet device 10. Thus, an extra marking step for unambiguously indicating the required orientation of the block 22 can be dispensed with.

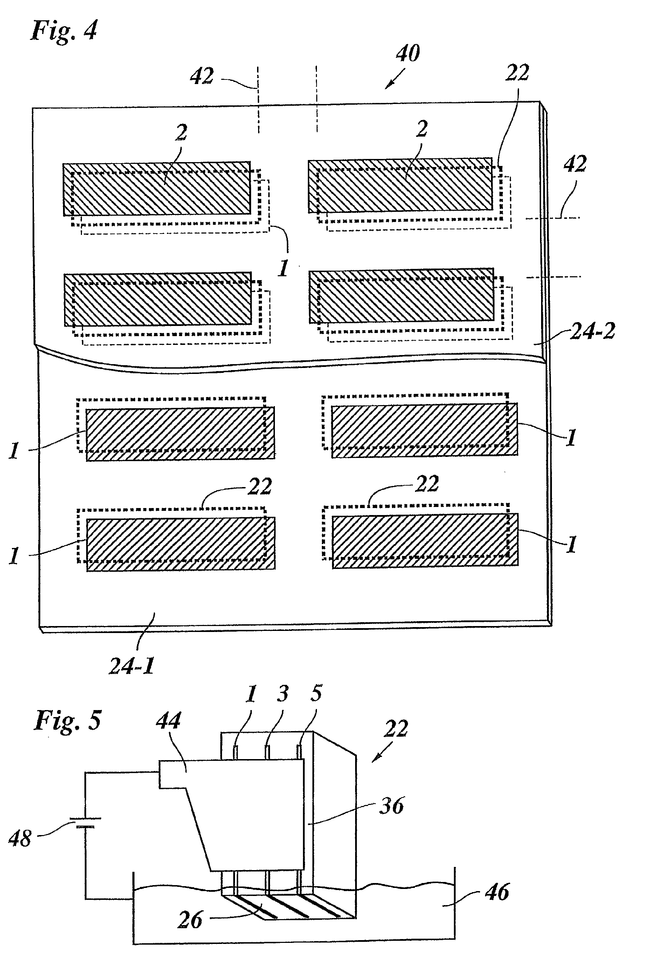

As is shown in figure 4, a plurality of blocks 22 for the actuators of the ink jet device 10 can be obtained in a single manufacturing process by dicing a larger wafer 40 of laminated ceramic material. The contours of the individual blocks 22 are indicated in figure 4 in bold dashed lines. These individual blocks are obtained by forming vertical and horizontal dicing cuts 42 in the wafer 40. The positions and widths of the dicing cuts 42 are indicated by dot-dashed lines in figure 4.

The wafer 40 is prepared by alternating steps of laminating green sheets 24-1, 24-2, which will later form the layers 24 of piezoelectric material, and forming patterns of internal electrodes 1, 2,... on each green sheet, e.g. by screen printing.

As is shown in the lower part of figure 4, the odd-numbered internal electrodes 1 are offset from the contours of the blocks 22 in the two mutually orthogonal directions of the dicing cuts 42, so that margins of the electrodes 1 at the right and lower edges in figure 4 will be cut away in the dicing step, whereas the other two edges of the electrodes 1 remain buried in the ceramic material. As is shown in the top part of figure 4, the even-numbered electrodes 2 are displaced from the contours of the blocks 22 in the opposite directions. This will finally lead to the alternating structure of odd-numbered electrodes exposed at the rear faces 26 and the first side faces 36 of the blocks 22 and the even-numbered electrodes exposed at the front faces 30 and the second side faces 38 of the blocks, as shown in figures 2 and 3.

When the required number of green sheets 24-1, 24-2, ... have been stacked one upon the other, the layered structure is sintered to form the ceramic wafer 40 which is then diced into the individual blocks 22.

As is symbolically shown in figure 5, the contact portions 34 at the rear edges of the electrodes 1, 3, 5 are formed by temporarily contacting the internal electrodes at their side edges exposed in the side face 36 of the block 22 by means of an auxiliary electrode 44, immersing the rear face 26 of the block into a galvanic bath 46 and applying a DC voltage of a voltage source 48 between the auxiliary electrode 44 and the galvanic bath 48. As a result, the contact portions 34 will grow on the edges of the electrodes 1, 3, 5 immersed in the galvanic bath. The contact portions of the even-numbered electrodes 2, 4 will be formed in an analogous way. Finally, the external electrodes 28, 32 are applied, e.g. by electroless plating, as is known in the art. Then, the contact portions 34 will assure a good electric contact between the internal electrodes and the external electrodes.

While only a specific embodiment of the invention has been described above, it will be understood that the invention is not limited to this embodiment but encompasses all modifications which a person skilled in the art might conceive of, as far as they fall within the scope of the appended claims. It will also be understood that the ideas of the present invention are applicable not only to piezo-electric actuators for ink jet devices but also all kinds of devices wherein multi-layer piezoelectric activators are used e.g. to achieve a large expansion or a relatively low activation voltage.

## Claims

1. A piezoelectric actuator (20) having a body (22) with a front face (30), a rear face (26) opposite to the front face, and first and second side faces (36, 38) opposite to one another, the body (22) being formed by several active layers (24) of piezoelectric material with internal electrodes (1, 2, 3, 4, 5) intervening therebetween, wherein the internal electrodes comprise a first group of electrodes (1, 3, 5) extending to the rear face (26) of the body (22) and connected to a first external electrode (28), and a second group (2, 4) of electrodes extending to the front face (30) of the body (22) and connected to a second external electrode (32), wherin each internal electrode (1, 2, 3, 4, 5) is in electrical contact with an associated one of the external electrodes (28,32) through a contact portion (34) that is galvanically grown on an exposed edge of the internal electrode, **characterized in that** the internal electrodes (1, 2, 3, 4, 5) are offset from the contours of the block (22) in mutually orthogonal directions such that the electrodes (1, 3, 5) of the first group extend to the first side face (36) of the block (22) and are buried in the block near the second side face (38) and the front face (30) thereof, whereas the electrodes (2, 4) of the second group extend to the second side face (38) of the block (22) and are buried in the block near the first side face (36) and the rear face (26).

2. Actuator according to claim 1, wherein the internal electrodes (1, 2, 3, 4, 5) of the first and second groups are arranged alternatingly in the block (22).

3. Actuator according to claim 2, wherein the total number of internal electrodes (1, 2, 3, 4, 5) is odd.

4. Method of manufacturing a piezoelectric actuator (20) for an ink jet device (10), comprising the steps of:
- forming a body (22) by laminating a plurality of layers (24) of piezoelectric material with internal electrodes (1, 2, 3, 4, 5) intervening therebetween, such that each internal electrode is exposed at one of opposite front and rear faces (30, 26) of the body (22) and is also exposed at only one of opposite side faces (36, 38) of the body,
- electrically contacting each internal electrode at the side face (36, 38) at which it is exposed,
- subjecting the body (22) to a galvanic process for growing contact portions (34) on the edges of each internal electrode (1, 2, 3, 4, 5) exposed at one of said front and rear faces (30, 26) of the body, and
- forming an external electrode (28, 32) on at least one of said front and rear faces (30, 26) of the body (22) for making permanent electrical contact with said contact portions (34) of the internal electrodes.
